# EUROPEAN PATENT SPECIFICATION

(11) **EP 1 623 612 B1**
(45) Date of publication and mention of the grant of the patent: **29.08.2007**
(21) Application number: 04750180.4
(22) Date of filing: 14.04.2004
(51) Int. Cl.: H05K 7/20, G06F 1/20

(54) **AN ACTUATION MEMBRANE FOR APPLICATION TO A CARD SLOT OF A SYSTEM**
EINE BETÄTIGUNGSMEMBRAN ZUR VERWENDUNG IN EINEM SYSTEMSKARTENSCHLITZ
MEMBRANE D'ENTRAINEMENT S'APPLIQUANT SUR UNE POSITION D'ENFICHAGE DE CARTE DANS UN SYSTEME

(30) Priority: 09.05.2003 US 435146; 05.03.2004 US 794242
(43) Date of publication of application: 08.02.2006
(73) Proprietor: INTEL CORPORATION, Santa Clara, CA 95052 (US)
(72) Inventor: DISTEFANO, Eric, Livermore, CA 94550 (US); POKHARNA, Himanshu, SanJose, CA 95134 (US)
(74) Representative: Goddar, Heinz J.
(86) International application number: PCT/US2004/011660
(87) International publication number: WO 2004/103048

(56) References cited:
- US-A- 5 861 703
- US-A- 5 914 856
- US-A1- 2002 175 596
- US-A1- 2002 184 907
- US-B1- 6 252 769
- US-B1- 6 430 042
- US-B1- 6 588 497

## Description

This application is a continuation-in-part of application no. 10/435,146 titled "Actuation Membrane To Reduce An Ambient Temperature of Heat Generating Device" (Attorney Docket No. 42.F15736) filed 05/09/2003 which is incorporated herein by reference.

### TECHNICAL FIELD

Embodiments described herein relate to heat management and more particularly to heat management using an actuation membrane.

### BACKGROUND

Heat management can be critical in many applications. Excessive heat can cause damage to or degrade the performance of mechanical, chemical, electric, and other types of devices. Heat management becomes more critical as technology advances and newer devices continue to become smaller and more complex, and as a result run hotter.

Modem electronic circuits, because of their high density and small size, often generate a substantial amount of heat. Complex integrated circuits (ICs), especially microprocessors, generate so much heat that they are often unable to operate without some sort of cooling system. Further, even if an IC is able to operate, excess heat can degrade an IC's performance and can adversely affect its reliability over time. Inadequate cooling can cause problems in central processing units (CPUs) used in personal computers (PCs), which can result in system crashes, lockups, surprise reboots, and other errors. The risk of such problems can become especially acute in the tight confines found inside laptop computers and other portable computing and electronic devices.

Prior methods for dealing with such cooling problems have included using heat sinks, fans, and combinations of heat sinks and fans attached to ICs and other circuitry in order to cool them. However, in many applications, including portable and handheld computers, computers with powerful processors, and other devices that are small or have limited space, these methods may provide inadequate cooling.

In particular, cooling devices mounted on the bottom of a motherboard present a more acute problem. Typically, there is less room between the bottom face of the mother board and the bottom skin of a portable computer (i.e., notebook computer). As a result, it becomes difficult to fit a device on the underside of the motherboard to reduce the temperature of heat generating devices mounted to the underside of the motherboard. Furthermore, mounting heat generating devices to the underside of the motherboard also creates the undesirable effect of sometimes generating a hot spot on the bottom skin of the notebook computer, further creating the need to reduce the temperature of the heat generating devices mounted on the bottom side of a motherboard. Hot spots on the bottom skin of a notebook computer are becoming even more commonplace today as the skin of notebooks are becoming ever thinner.

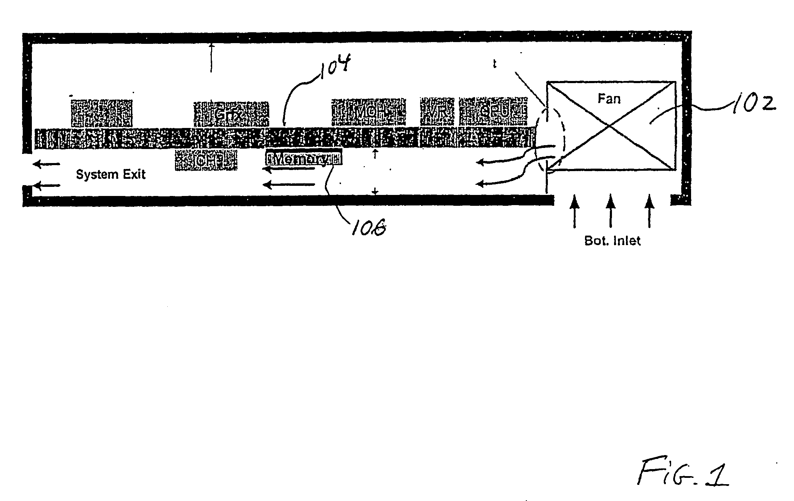

One possible solution to reduce the temperature of the heat generating devices mounted on the bottom side of a motherboard is illustrated in **Figure 1**. As illustrated in **Figure 1**, a fan 102 may be placed on a side of the motherboard 104 to generate a flow of air across a top side and bottom side of the motherboard to cool components 106 mounted on both sides of the motherboard. However, such a thermal solution takes away from the capability to cool heat generating devices mounted on the top side which create relatively larger amounts of heat (e.g., central processing units). Futhermore, the use of fans also creates undesirable noise.
US 6 252 769 B1 discloses a device for increasing heat transfer from an object having at least one oscillating membrane for generating an air motion in the surrounding of the object. The oscillating membrane includes a nozzle which produces an air stream directed to a ground plate and air cooling flanges attached to heat-producing electronics.
US 6 430 042 B1 discloses a means for cooling semiconductor elements in a housing of a portable computer. A fan draws an air stream through an enclosed duct which extends through the housing of the portable computer The CPU and other heat-generating elements inside the housing are in thermal contact to the exterior of the duct.
US 5 861 703 discloses a piezoelectric fan assembly. A piezoelectric element causes a single fan blade to vibrate. The fan blade produces an air stream through the housing of the assembly. The fan assembly may be used to cool electronic components.
The present invention relates to an apparatus as defined in claim 1.

### BRIEF DESCRIPTION OF THE DRAWINGS

**Figure 1** is a perspective illustration of a prior art thermal solution;

**Figure 2** is a cut-away illustration of a system incorporating an actuation membrane unit according to one embodiment;

**Figure 3** is an illustration of an actuation membrane unit according to one embodiment; and

**Figure 4** is an illustration of an example for using an actuation membrane unit for a card slot of a system.

### DETAILED DESCRIPTION

Embodiments of an actuation membrane to generate air movement in a direction of a heat generating device to reduce a temperature of the device and/or to reduce an ambient temperature of the heat generating device, are disclosed. In the following description, numerous specific details are set forth. However, it is understood that embodiments may be practiced without these specific details. In other instances, well-known circuits, structures and techniques have not been shown in detail in order not to obscure the understanding of this description.

Reference throughout this specification to "one embodiment" or "an embodiment" indicate that a particular feature, structure, or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

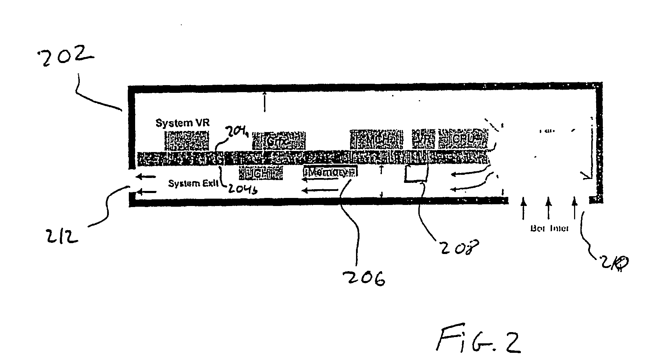

In one embodiment, as illustrated in **Figure 2,** a portable computer system 202 (such as a notebook computer, tablet personal computer, laptop computer, etc.) includes a motherboard 204, to which units are mounted. The motherboard includes a top side204a and a bottom side 204a. In one embodiment, the space between the top side 204a of the mother board and the inside of the computer chassis (otherwise referred to as the "skin") is larger than the space between the bottom side 204b of the mother board and the inside of the computer chassis.

For example, as illustrated in the embodiment of **Figure 2,** the space between the top side 204a of the mother board and the inside of the computer chassis is 8.2 mm, and the space between the bottom side 204b of the mother board and the inside of the computer chassis is only 5.5 mm. The distance between the top side 204a and the bottom side 204b of the motherboard and the computer chassis may vary in alternative embodiments.

Electronic components may be mounted on top side 204a and the bottom side 204b, as illustrated. In particular, as illustrated in **Figure 1,** a memory unit 206 is mounted to the bottom side 204b of the motherboard. Alternatively, other heat generating devices may be mounted on the bottom side of the motherboard, such as a CPU, a chipset, a graphics controller (Grfx), or a wireless mini card.

In the embodiment illustrated in **Figure 2,** an actuation membrane 208 is provided to generate streams of air in the direction of the memory unit, or other heat generating device(s). By generating streams of air in the direction of the heat generating device(s), the ambient temperature of the heat generating device, the temperature of the heat generating device, and/or the temperature of the inside and outside of the local area of the computer chassis may all be reduced. In alternative embodiments, an actuation membrane may be mounted on the top side 204a of the motherboard and positioned to generate a stream of air in the direction of heat generating devices mounted on the top side 204a of the motherboard.

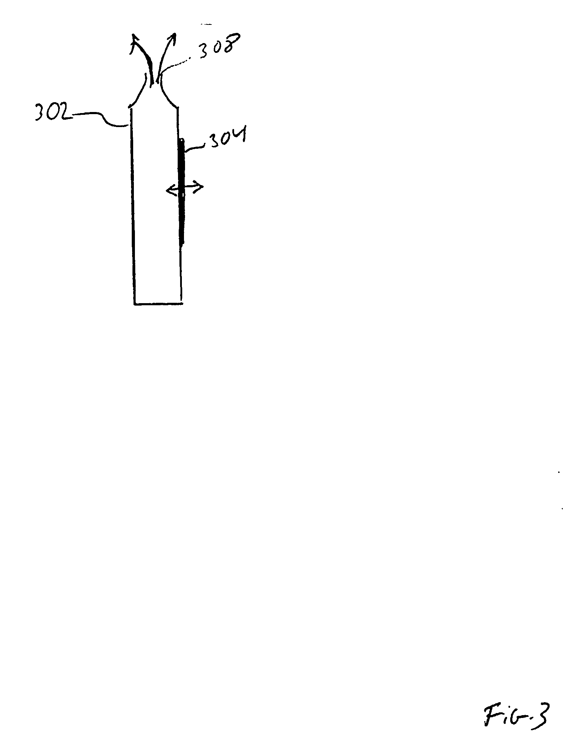

In one embodiment illustrated in **Figure 3,** the actuation membrane unit 302 includes a piezoelectric or electromagnetic membrane 304 that oscillates inward and outward, to pull air into the unit and force air out of the unit, respectively, to generate jet stream of air. More specifically, as shown in **Figure 3,** when the membrane 304 oscillates outward away from the unit 302, air is pulled into the unit through the relatively small opening 308. When the membrane oscillates inward, the air is forced out of the opening 308 of the unit 302 to produce a jet stream of air.

In one embodiment, the actuation membrane unit 302 oscillation in the range of 20-200 Hz. In alternative embodiments, higher and lower ranges of oscillation are provided. Furthermore, in one embodiment, the dimensions of the actuation membrane unit include a height of 5.5 mm or less, a length of 40 mm or less, and a width of 40 mm or less. In alternative embodiments, the dimensions of the actuation membrane unit may vary.

In one embodiment, as further illustrated in **Figure 2,** the system includes an inlet 210 to accept external air into the system, and may further include a system exit 212 to release the warmer interior air that is forced out by the jet streams generated by the actuation membrane unit 302.

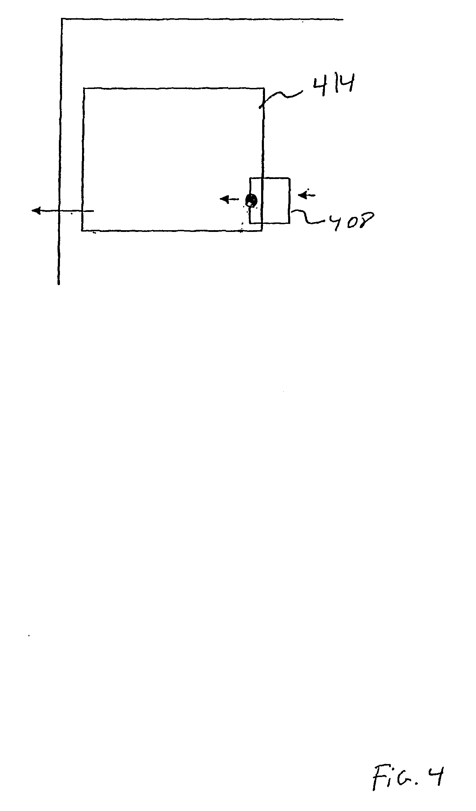

**Figure 4** illustrates an example helpful for understanding the invention. As illustrated in **Figure 4,** an actuation membrane 408 is provided to generate streams of air in the direction of card slot 414. By generating streams of air in the direction of the card slot 414, the ambient temperature of the slot, the temperature of card inserted in the slot, and/or the temperature of the inside and outside of the local area of the computer chassis may all be reduced. In one embodiment, the actuation membrane is positioned on a perimeter of the slot 414, or alternatively outside the perimeter of the card slot, to generate a stream of air through the slot and exit through an exterior entrance of the slot.

In one embodiment, the card slot may be sized to accept credit-card sized removable modules, which may be used to attach modems, network adapters, sound cards, radio transceivers, solid state disks and hard disks to a portable computer. The card slot may be configured for a PC card, a PCMCIA card, a CardBus card, or other cards. In one embodiment, the card slot may be configured to receive a card 85.6 mm long by 54 mm wide (3.37" x 2.126"). The height of the card slot may vary to accommodate different types of cards, such as a 3.3 mm thick for a Type I card, a 5.0 mm thickness for a Type II card, a 10.5 mm thickness for a Type III card, and a 16 mm thickness for a Type IV card. In alternative embodiments, the dimensions of the card slot may vary to receive cards of other dimensions and formats.

These embodiments have been described with reference to specific exemplary embodiments thereof. It will, however, be evident to persons having the benefit of this disclosure that various modifications and changes may be made to these embodiments without departing from the broader spirit and scope of the embodiments described herein. The specification and drawings are, accordingly, to be regarded in an illustrative rather than a restrictive sense.

## Claims

1. An apparatus, comprising:
an actuation membrane unit to generate air movement in a direction of a heat generating device to reduce an ambient temperature of the device, **characterized in that** the heat generating device is at least one of a group comprising of a memory unit, a chipset, a graphics processor, and a processor, and the heat generating device and the actuation membrane unit are attached to a bottom side of a motherboard placed within an interior chamber of a portable computer to reduce the temperature of the device.

2. The apparatus of claim 1, wherein the actuation membrane unit includes a piezoelectric actuation membrane.

3. The apparatus of claim 1, wherein the actuation membrane unit includes an electromagnetic actuation membrane.

4. The apparatus any one of the proceeding claims, wherein a space between the bottom side of the motherboard and an inner surface of a system chassis is 5.5 mm or less.

## Patentansprüche

1. Vorrichtung, umfassend:
eine Antriebsmembran-Einheit zur Erzeugung von Luftbewegung in einer Richtung einer wärmeerzeugenden Vorrichtung zur Verringerung einer Umgebungstemperatur der Vorrichtung, **dadurch gekennzeichnet, daß** die wärmeerzeugende Vorrichtung zumindest ein Element einer Gruppe ist, welche eine Speichereinheit, einen Chipsatz, einen Grafikprozessor und einen Prozessor umfaßt, und daß die wärmeerzeugende Vorrichtung und die Antriebsmembran-Einheit an einer Unterseite von einer Hauptplatine angebracht sind, welche innerhalb eines Innenraums eines tragbaren Computers angeordnet ist, um die Temperatur der Vorrichtung zu verringern.

2. Vorrichtung nach Anspruch 1, bei der die Antriebsmembran-Einheit eine piezoelektrische Antriebsmembran umfaßt.

3. Vorrichtung nach Anspruch 1, bei der die Antriebsmembran-Einheit eine elektromagnetische Antriebsmembran umfaßt.

4. Vorrichtung nach einem der vorangegangenen Ansprüche, bei der ein Raum zwischen der Unterseite der Hauptplatine und einer Innenfläche eines Systemchassis 5,5 mm oder weniger beträgt.

## Revendications

1. Dispositif, comportant une unité à membrane d'actionnement pour générer un déplacement d'air dans la direction d'un dispositif générateur de chaleur afin de réduire la température ambiante du dispositif, **caractérisé en ce que** le dispositif générateur de chaleur est au moins un de ceux du groupe comprenant une unité de mémoire, un ensemble de puces, un processeur graphique et un processeur, et le dispositif générateur de chaleur et l'unité à membrane d'actionnement sont fixés sur le côté inférieur d'une carte-mère placée dans une chambre intérieure d'un ordinateur portable pour réduire la température du dispositif.

2. Dispositif selon la revendication 1, dans lequel l'unité à membrane d'actionnement comporte une membrane d'actionnement piézoélectrique.

3. Dispositif selon la revendication 1, dans lequel l'unité à membrane d'actionnement comporte une membrane d'actionnement électromagnétique.

4. Dispositif selon l'une quelconque des revendications précédentes, dans lequel un espace entre le coté inférieur de la carte-mère et une surface intérieure du châssis du système est de 5,5 mm ou moins.
